# EUROPÄISCHE PATENTSCHRIFT

(11) **EP 1 364 459 B1**
(45) Veröffentlichungstag und Bekanntmachung des Hinweises auf die Patenterteilung: **11.04.2007**
(21) Anmeldenummer: 02714058.1
(22) Anmeldetag: 22.02.2002
(51) Int. Cl.: H03F 1/52, G05B 9/02

(54) **SICHERHEITSSCHALTVORRICHTUNG**
SAFETY SWITCH DEVICE
DISPOSITIF DE COMMUTATION DE SECURITE

(30) Priorität: 01.03.2001 DE 10109864
(43) Veröffentlichungstag der Anmeldung: 26.11.2003
(73) Patentinhaber: SIEMENS AKTIENGESELLSCHAFT, 80333 München (DE)
(72) Erfinder: HALLER, Herbert, 92260 Fichtenhof (DE); HEBERLEIN, Thomas, 92694 Etzenricht (DE); KRÄMER, Werner, 92421 Schwandorf (DE)
(86) Internationale Anmeldenummer: PCT/DE2002/000666
(87) Internationale Veröffentlichungsnummer: WO 2002/071600

(56) Entgegenhaltungen:
- EP-A- 0 853 368
- DE-U- 29 923 605
- US-A- 6 049 741

## Beschreibung

Die Erfindung bezieht sich auf eine Sicherheitsschaltvorrichtung.

Eine Sicherheitsschaltvorrichtung wird in Schaltanlagen eingesetzt, um eine erhöhte Sicherheit zu ermöglichen. Die Sicherheitsschaltvorrichtung überwacht hierzu eine externe elektrische Einrichtung und schaltet in Abhängigkeit des Überwachungsergebnisses die Energieversorgung zu einem elektrischen Gerät. Gerät und Einrichtung können dasselbe sein. Der Sicherheitsschaltvorrichtung ist also sowohl eine Überwachungsfunktion als auch eine Arbeitsfunktion, beispielsweise die Schaltfunktion, zugeordnet. Unter elektrischer Einrichtung wird hierbei sowohl eine einzelne Komponente als auch ein Strom- oder Schaltkreis verstanden. Beispielsweise wird mittels der Sicherheitsschaltvorrichtung der Einschaltkreis und der nicht Not-Aus-Schaltkreis für einen Motor überwacht. Das elektrische Gerät wäre in diesem Fall der Motor, also ein Verbraucher. Die Sicherheitsschaltvorrichtung schaltet in der Regel den Verbraucher nicht unmittelbar, sondern mittelbar über spezielle Schaltgeräte. Insbesondere steuert die Sicherheitsschaltvorrichtung ein verbraucherspezifisches Schaltgerät, beispielsweise einen Motorschütz oder einen Hilfsschütz für einen solchen Motorschütz.

Die Sicherheitsschaltvorrichtung weist üblicherweise eine Schaltung auf, die die Überwachungsfunktion übernimmt, und die elektromechanische Schaltelemente umfasst, beispielsweise Relais, um den Stromfluss zum besagten Hilfsschütz zu unterbrechen. Eine derartige Sicherheitsschaltvorrichtung wird üblicherweise in weniger komplexen Anlagen oder Anlagenteilen eingesetzt, in denen nur wenige Einrichtungen überwacht oder wenige Geräte geschaltet werden müssen.

Die Sicherheitsschaltvorrichtung wird auch als Sicherheitskombination bezeichnet. Beispiele für derartige Sicherheitskombinationen sind die "SIGUARD"-Sicherheitskombinationen der Baureihe 3TK28 der Siemens AG. Diese Sicherheitskombinationen sind im Vergleich zu einer Sicherheitseinrichtung auf Basis einer speicherprogrammierbaren Steuerung deutlich weniger aufwendig. Eine solche Sicherheitseinrichtung ist sehr flexibel und wird insbesondere in komplexen Einlagen eingesetzt. Sie wird durch eine entsprechende Programmierung an die speziellen Anforderungen angepasst und übernimmt im allgemeinen auch Überwachungs- und Steuerungsfunktionen. Ein Beispiel für eine solche Sicherheitseinrichtung ist beispielsweise die "SIMATIC"-Baureihe der Siemens AG.

Für die Sicherheitsschaltvorrichtung bestanden bis vor kurzem gesetzliche Normen, wonach insbesondere die Schaltelemente der Vorrichtung als elektromechanische Bauteile ausgebildet sein mussten. Diese Anforderung ist mittlerweile entfallen. Die sicherheitstechnischen Anforderungen an eine solche Sicherheitsschaltvorrichtung werden nunmehr beispielsweise in der Norm EN954-1 geregelt. In dieser Norm sind unterschiedliche Kategorien vorgesehen, wobei die Kategorie 4 der höchsten Sicherheitsstufe entspricht. Um die Kategorie 4 zu erreichen, ist es notwendig, dass alle sicherheitstechnisch relevanten Bauteile redundant ausgeführt sind.

Da die Schaltung der Sicherheitsschaltvorrichtung nunmehr nicht mehr ausschließlich elektromechanisch ausgebildet sein muss, wird der Einsatz von elektronischen Bauteilen angestrebt. Insbesondere bietet sich aufgrund der Überwachungs- und Arbeitsfunktion der Einsatz eines Mikroprozessors an. Da dieser ein sicherheitsrelevantes Bauteil ist, muss er für die Kategorie 4 der EN954-1 redundant ausgebildet sein.

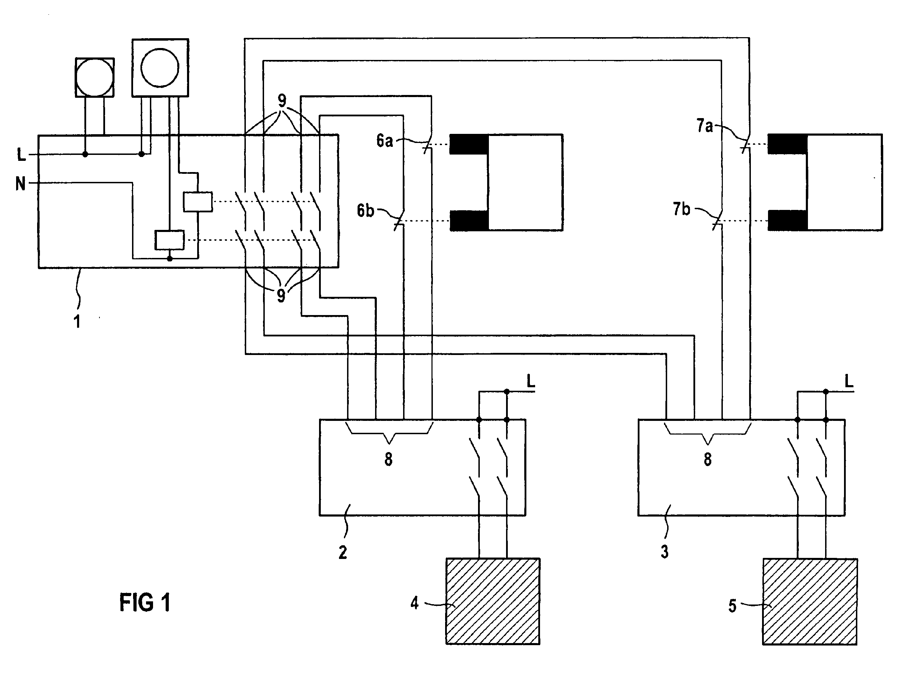

FIG 1 zeigt einen elektrischen Schaltungsaufbau gemäß dem Stand der Technik mit drei Sicherheitsschaltvorrichtungen 1, 2, 3, auch als Sicherheitskombination bezeichnet, zur selektiven und übergeordneten sicheren Abschaltung zweier Verbrauchergruppen 4, 5. Die beiden Verbrauchergruppen 4 und 5 sind durch Unterbrechung der Stromversorgung des Hilfs- oder Hauptenergieanschlusses L mittelbar oder unmittelbar jede für sich von der zugeordneten Sicherheitsschaltvorrichtung 2 bzw. 3 abschaltbar. Über Schutztür-Kontakte 6a, 6b, die mit einem Sensoreingang 8 der als Not-Aus-Gerät 2 ausgeführten Sicherheitsschaltvorrichtung verbunden sind, ist die Verbrauchergruppe 4 abschaltbar. Über Schutztür-Kontakte 7a, 7b, die ebenfalls mit dem Sensoreingang 8 der als Not-Aus-Gerät ausgeführten Sicherheitsschaltvorrichtung 3 verbunden sind, ist die Verbrauchergruppe 5 abschaltbar. Durch die weitere als Not-Aus-Gerät ausgeführte Sicherheitsvorrichtung 1 sind beide Verbrauchergruppen 4 und 5 übergeordnet abschaltbar. Eine derartige beispielhafte Verknüpfung von Sicherheitskombinationen 1, 2, 3 wird als Kaskadierung bezeichnet. Die Not-Aus-Geräte 1, 2 und 3 sind nach dem Stand der Technik als Relais- bzw. Schützsicherheitskombinationen ausgeführt, die potentialfreie sichere Ausgänge 9 besitzen. An die sicheren Ausgänge 9 des Not-Aus-Geräts 1, wobei diese hier nur für das Not-Aus-Gerät 1 gemäß FIG 1 dargestellt sind, sind zwei getrennte Sensorkreise mit den Schutztür-Kontakten 6a, 6b und 7a, 7b angeschlossen. Dadurch schaltet das untergeordnete Not-Aus-Gerät 2 oder 3 ab, wenn das übergeordnete Not-Aus-Gerät 1 abgeschaltet oder wenn einer der Schutztür-Kontakte 6a, 6b, 7a, 7b betätigt wird.

Der erforderliche Sicherheitsaufwand zum Schutz gegenüber gefährlichen Betriebszuständen an Maschinen ist durch entsprechende Kategorien in der Norm EN60204 definiert. Im vorliegenden Beispiel werden gemäß Kategorie 3, 4 zwei Freigabekreise verwendet, so dass zum Anschluss beider Verbrauchergruppen 4, 5 jeweils vier Leitungen an das übergeordnete Not-Aus-Gerät 1 angeschlossen werden müssen. Demzufolge ist die Kaskadierung von Sicherheitskombinationen mit erheblichem Verdrahtungsaufwand verbunden. Außerdem werden hierbei zum Auftrennen der untergeordneten Sensorleitungen mehrere Ausgänge benötigt, die anderweitig nicht mehr zur Verfügung stehen.

Der Erfindung liegt daher die Aufgabe zugrunde, eine Sicherheitsschaltvorrichtung anzugeben, die eine Kaskadierung mit geringem Verdrahtungsaufwand unter Gewährleistung einer hohen Sicherheitskategorie ermöglicht.

Die Aufgabe wird gelöst mit den Merkmalen gemäß Anspruch 1.

Besonders vorteilhaft ist es, wenn der sichere Ausgang über eine einadrige Leitung mit dem sicheren Eingang mindestens einer weiteren gleichartigen Sicherheitsschaltvorrichtung verbunden ist. Eine derartige Kaskadierung mit einer einadrigen Leitung erfordert nur geringen Verdrahtungsaufwand. Dies wirkt sich bei einer Kaskadierung einer Vielzahl von Sicherheitskombinationen besonders vorteilhaft aus. Die Verdrahtung mit einer einadrigen Leitung wird dadurch möglich, dass das Bezugspotential der beteiligten Sicherheitskombinationen die gemeinsame Masseversorgung ist.

Weitere vorteilhafte Ausführungsformen sind den Unteransprüchen zu entnehmen.

Ein Ausführungsbeispiel der Erfindung wird im folgenden anhand einer Zeichnung näher erläutert. Es zeigen:
- FIG 2: eine erfindungsgemäße Sicherheitsschaltvorrichtung und
- FIG 3: ein Schaltbild mit Kaskadierung von erfindungsgemäßen Sicherheitsschaltvorrichtungen

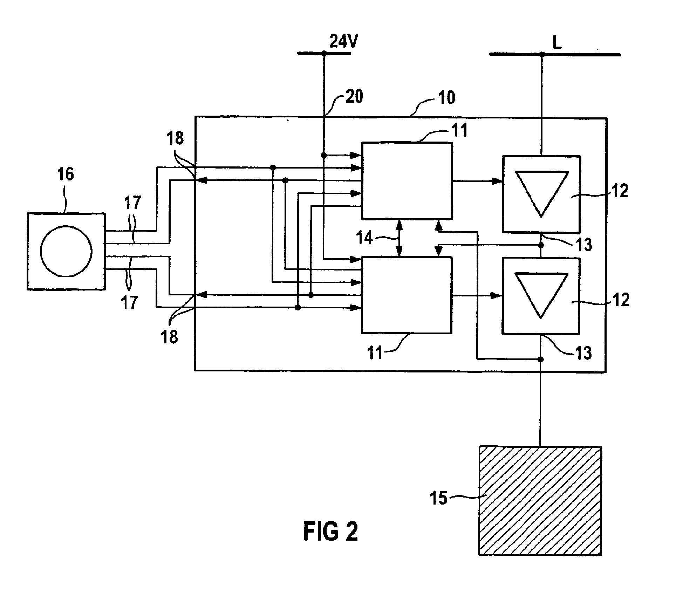

Eine erfindungsgemäße Sicherheitsschaltvorrichtung 10 gemäß FIG 2, die auch als Sicherheitskombination oder Not-Aus-Überwachungsgerät bezeichnet wird, umfasst zwei Auswerteschaltungen 11, die üblicherweise jeweils mit einem Mikroprozessor ausgestattet sind, und jeweils redundant aufgebaute elektronische Schalter 12 ansteuern. Die Ausgänge 13 der beiden zueinander in Reihe geschalteten Schalter 12 sind mit den Auswerteschaltungen 11 verbunden und werden durch diese überwacht. Hierzu steuern die Auswerteschaltungen 11 während des Betriebs die Schalter 12 mit einem Testsignal an und werten den Zustand am Ausgang 13 des jeweiligen Schalters 12 aus. Durch redundanten Aufbau der zwei Auswerteschaltungen 11, die über eine verbindungsleitung 14 miteinander verbunden sind und sich ebenfalls über diese gegenseitig überwachen, sowie der elektronischen Schalter 12 werden die Anforderungen einer höheren Sicherheitskategorie 3, 4 gemäß der Norm EN60204 erfüllt und damit ein sicherer Ausgang der Sicherheitsschaltvorrichtung 10 geschaffen, an den der Verbraucher 15 angeschlossen ist. Zeigt ein an die Sicherheitsschaltvorrichtung 10 angeschlossener Sensor 16, der wie im vorliegenden Beispiel ein Not-Aus-Taster oder auch ein Schutztür-Kontakt etc. sein kann, einen gefährlichen Zustand an, so wird die Stromversorgung zum angeschlossenen Verbraucher 15 durch die elektronischen Schalter 12 unterbrochen, d.h. es erfolgt eine Schaltung in den sicheren Aus-Zustand. Der Sensor 16, d.h. der Not-Aus-Taster, ist über redundante Leitungen 17 und über ebenfalls redundant aufgebaute Sensoreingänge 18 der Sicherheitsschaltvorrichtung 10 an die beiden Auswerteschaltungen 11 angeschlossen. Die Auswerteschaltungen 11 werten den Schaltzustand des Sensors 16 aus und steuern ggf. die zwei redundant aufgebauten elektronischen Schalter 12 an. Außerdem dienen die Auswerteschaltungen 11 zur Überwachung und zum Test des Sensors 16 im Betrieb.

Somit stellt die Sicherheitsschaltvorrichtung 10 den Zustand seines Ausgangs 19 in Abhängigkeit vom Ansprechen eines Sensors 16 sicher her, d.h. der angeschlossene Verbraucher 15 wird sicher geschalten. "Sicher" bedeutet hier, dass im Fehlerfall irgendeiner überwachten Komponente, sei es bei Leitungsbruch oder bei einem Ausfall eines der Schalter 12 etc., stets ein sicherer Zustand am Ausgang 19 der Sicherheitsschaltvorrichtung 10 hergestellt wird.

Neben den potentialfreien Sensoreingängen 18 ist die Sicherheitsschaltvorrichtung 10 mit einem potentialgebundenen, einkanaligen Eingang 20 versehen, der mit den Auswerteschaltungen 11 elektrisch verbunden ist und von diesen überwacht wird. Solange an dem Eingang 20 ein Potential, z.B. 24 V, anliegt, sind die beiden redundant aufgebauten elektronischen Schalter 12 im leitenden Zustand. Liegt z.B. als Folge eines Not-Aus-Befehls oder aufgrund eines gefährlichen Zustands kein Potential an dem Eingang 20 an, so werden die Schalter 12 über die Auswerteschaltungen 11 in den nichtleitenden Zustand geschalten. Auch über die Sensoreneingänge 18 darf kein gefährlicher Zustand angezeigt werden. Der Eingang 20 ist als zusätzliche Sicherheitsbedingung anzusehen.

Bei der Anwendung gemäß FIG 2 ist dieser zusätzliche Sensoreingang 20 durch Anlegen des Potentials 24 V inaktiv geschalten, d.h. es liegt eine Stand-alone-Funktionalität vor.

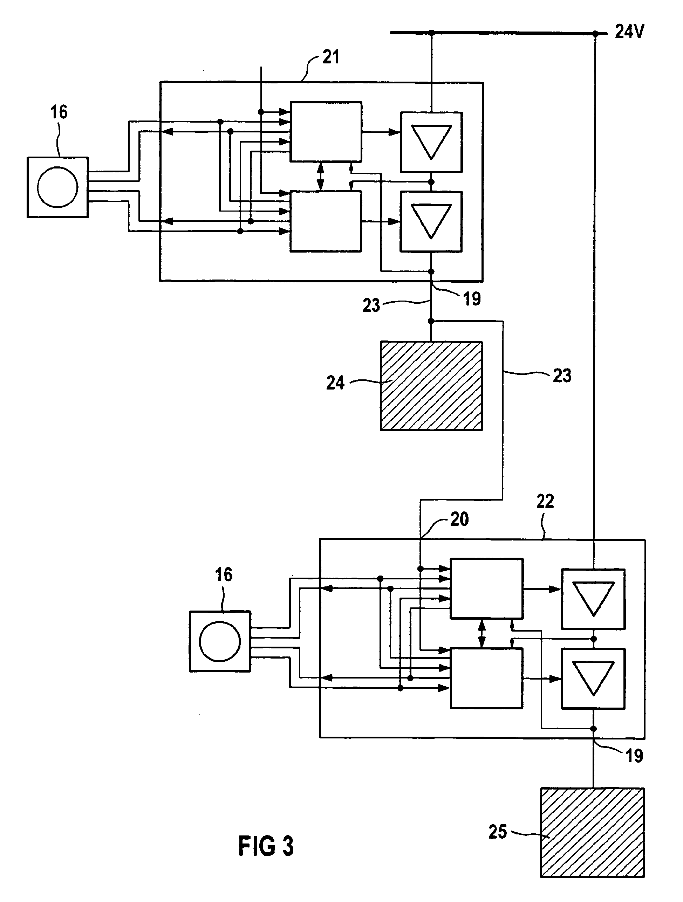

Der besondere Vorteil des zusätzlichen Sensor-Eingangs 20 liegt darin, dass er eine einfache Kaskadierung von Sicherheitskombinationen mit einer einadrigen Leitung 23 gemäß FIG 3 ermöglicht und daher auch als Kaskadiereingang bezeichnet wird. In FIG 3 ist die Kaskadierung von zwei Sicherheitskombinationen 21, 22 der oben beschriebenen Art dargestellt. Die Einzelkomponenten und Anschlüsse dieser beiden Sicherheitsschaltvorrichtungen 21 und 22 tragen die Bezugszeichen gemäß der in FIG 2 beschriebenen Sicherheitsschaltvorrichtung 10. Der sichere Ausgang 19 der Sicherheitsschaltvorrichtung 21, die hier als übergeordnete Sicherheitsschaltvorrichtung eingesetzt ist, ist über die einadrige Leitung 23 mit einem Verbraucher 24 und mit dem potentialgebundenen, einkanaligen Eingang 20 der weiteren Sicherheitsschaltvorrichtung 22 verbunden. Der an die weitere Sicherheitsschaltvorrichtung 22 angeschlossene Verbraucher 25 wird im Gefahrenzustand von dieser in den Aus-Zustand geschalten. Bei einem Not-Aus-Befehl in der übergeordneten Sicherheitsschaltvorrichtung 21 schaltet nicht nur der Verbraucher 24 sicher ab, sondern auch der Verbraucher 25, da die Zuführung des 24 V-Potentials an den zusätzlichen Sensoreingang 20 der Sicherheitsschaltvorrichtung 22 durch die übergeordnete Sicherheitsschaltvorrichtung 21 unterbrochen ist. Somit können Abschaltgruppen mit mehreren Verbrauchern durch Verdrahtung des Kaskadiereingangs 20 realisiert werden, indem eine einadrige Leitung 23 vom sicheren Ausgang 19 der übergeordneten Sicherheitsschaltvorrichtung 21 an den Kaskadiereingang 20 der untergeordneten Sicherheitsschaltvorrichtung 22 geführt wird. Selbst ein Leitungsbruch der einadrigen Leitung 23 führt den an die untergeordnete Sicherheitsschaltvorrichtung 22 angeschlossenen Verbraucher 25 in den sicheren Zustand.

Bei Betätigung des Sensors 16 an der untergeordneten Sicherheitsschaltvorrichtung 22 wird nur der daran angeschossene Verbraucher 25 abgeschaltet.

Eine Verdrahtung durch Kaskadierung mit der Leitung 23 ist nur zulässig, wenn Fehler, z.B. ein Querschluss gegen 24 V innerhalb des Schaltschranks, angeschlossen werden kann. Ansonsten könnte ein solcher Querschluss einen tatsächlich nicht vorhandenen sicheren Zustand vortäuschen.

## Patentansprüche

1. Sicherheitsschaltvorrichtung (10,21,22) mit folgenden Merkmalen:
a) mit einem ersten und einem in Reihe geschalteten zweiten elektronischen Schalter (12) zur sicherheitsgerichteten Unterbrechung eines Stromkreises, über den die Abschaltung der Stromversorgung eines Verbrauchers (15,24,25) steuerbar ist,
b) mit mindestens einer ersten und einer zweiten Auswerteschaltung (11), von denen die erste (11) zumindest mit dem ersten Schalter (12) und die zweite (11) zumindest mit dem zweiten Schalter (12) zu dessen Ansteuerung verbunden ist,
c) die Auswerteschaltungen (11) sind als Test- und Überwachungseinrichtungen ausgeführt, die durch Ansteuerung mit einem Testsignal während des Betriebs die einwandfreie Funktion des jeweiligen Schalters (12) testen und überwachen,
d) mit einem sicheren potentialgebundenen Ausgang (19), der zur Überwachung seines Potentialzustands mit den Auswerteschaltungen (11) verbunden ist, wobei dieser Potentialzustand im fehlerlosen Betrieb dem Potentialzustand an den Eingängen der Schalter (12) entspricht und
e) mit einem sicheren potentialgebundenen, einkanaligen Eingang (20), der mit den beiden Auswerteschaltungen (11) zur Auswertung seines Potentialzustands verbunden ist, die derart ausgebildet sind, dass sie abhängig von diesem Potentialzustand die Schalter (12) ansteuern.

2. Sicherheitsschaltvorrichtung nach Anspruch 1, **gekennzeichnet durch** einen nichtpotential gebundenen oder potential gebundenen Sensor-Eingang (18), der mit den beiden Auswerteschaltungen (11) zur Auswertung seines Potentialzustands verbunden ist, wobei die Auswerteschaltungen (11) derart ausgebildet sind, dass diese abhängig vom ausgewerteten Potentialzustand des Sensoreingangs (18) die Schalter (12) ansteuern.

3. Sicherheitsschaltvorrichtung nach Anspruch 1 oder 2, **dadurch gekennzeichnet, dass** der sichere Ausgang (19) über eine einadrige Leitung (23) mit dem sicheren Eingang (20) mindestens einer weiteren gleichartigen Sicherheitsschaltvorrichtung verbunden ist.

4. Sicherheitsschaltvorrichtung nach einem der vorangehenden Ansprüche, **dadurch gekennzeichnet, dass** der sichere Ausgang (19) die Abschaltung der Stromversorgung eines Verbrauchers (15) steuert.

5. Sicherheitsschaltvorrichtung nach einem der vorangehenden Ansprüche, **dadurch gekennzeichnet, dass** der Sensoreingang (18) mit Schutztür-Kontakten als Sensor verbunden ist.

6. Sicherheitsschaltvorrichtung nach einem der vorangehenden Ansprüche, **dadurch gekennzeichnet, dass** der Sensoreingang (18) mit einem Not-Aus-Schalter (16) als Sensor verbunden ist.

7. Sicherheitsschaltvorrichtung nach einem der vorangehenden Ansprüche, **dadurch gekennzeichnet, dass** der Eingang (20) durch externe Beschaltung inaktivierbar ist.

## Claims

1. Safety switch device (10, 21, 22) with the following features:
a) with a first and a series-connected second electronic switch (12) for safety-oriented interruption of a circuit, via which the disconnection of the power supply of a load (15, 24, 25) is able to be controlled,
b) with at least one first and one second evaluation circuit (11), of which the first (11) is connected to at least the first switch (12) and the second (11) to at least the second switch (12) for the pupose of controlling these switches,
c) the evaluation circuits (11) are embodied as testing and monitoring devices, which, when controlled by a test signal during operation, test and monitor the correct function of the switch (12) concerned,
d) with a safe floating output (19), which for monitoring its potential state is connected to the evaluation circuits (11), with this potential state in error-free operation corresponding to the potential state at the inputs of the switches (12), and
e) with a safe non-floating single-channel input (20) which is connected for evaluation of its potential state to the two evaluation circuits (11), which are embodied so that they control the switches (12) as a function of this potential state.

2. Safety switch device according to claim 1, **characterized by** a floating or non-floating sensor input (18) which is connected to the two evaluation circuits (11) for evaluation of its potential state, with the evaluation circuits (11) being embodied such that these circuits control the switches (12) as a function of the evaluated potential state of the sensor input (18).

3. Safety switch device according to claim 1 or 2, **characterized in that**, the safe output (19) is connected via a single-wire line (23) to the safe input (20) of at least one further similar type of safety switch device.

4. Safety switch device according to one of the previous claims, **characterized in that**, the safe output (19) controls the disconnection of the power supply of a load (15).

5. Safety switch device according to one of the previous claims, **characterized in that** the sensor input (18) is connected to protective door contacts as a sensor.

6. Safety switch device according to one of the previous claims, **characterized in that** the sensor input (18) is connected to an emergency-off switch (16) as a sensor.

7. Safety switch device according to one of the previous claims, **characterized in that** the input (20) can be deactivated by an external protective circuit.

## Revendications

1. Dispositif de commutation de sécurité (10, 21, 22) ayant les caractéristiques suivantes:
a) un premier et un deuxième interrupteur électronique (12) branchés en série pour la coupure de sécurité d'un circuit de courant par l'intermédiaire duquel la coupure de l'alimentation en courant d'un consommateur (15, 24, 25) est commandable,
b) au moins un premier et un deuxième circuit d'évaluation (11), le premier (11) étant relié au moins au premier interrupteur (12) pour la commande de celui-ci et le deuxième (11) étant relié au moins au deuxième interrupteur (12) pour la commande de celui-ci,
c) les circuits d'évaluation (11) sont réalisés comme des dispositifs de test et de surveillance qui, par une commande avec un signal de test pendant le fonctionnement, testent et surveillent le bon fonctionnement de l'interrupteur respectif (12),
d) une sortie (19), reliée au potentiel et sûre, qui est reliée aux circuits d'évaluation (11) pour la surveillance de son état de potentiel, cet état de potentiel correspondant lors d'un fonctionnement sans erreur à l'état de potentiel aux entrées des interrupteurs (12), et
e) une entrée (20), reliée au potentiel et sûre, qui est reliée aux deux circuits d'évaluation (11) pour l'évaluation de son état de potentiel, les circuits d'évaluation étant conçus de telle sorte qu'ils commandent les interrupteurs (12) en fonction de cet état de potentiel.

2. Dispositif de commutation de sécurité selon la revendication 1, **caractérisé par** une entrée de capteur (18), reliée ou non au potentiel, qui est reliée aux deux circuits d'évaluation (11) pour l'évaluation de son état de potentiel, les circuits d'évaluation (11) étant conçus de telle sorte qu'ils commandent les interrupteurs (12) en fonction de l'état de potentiel évalué de l'entrée de capteur (18).

3. Dispositif de commutation de sécurité selon la revendication 1 ou 2, **caractérisé par le fait que** la sortie sûre (19) est reliée par l'intermédiaire d'une ligne unifilaire (23) à l'entrée sûre (20) au moins d'un autre dispositif de commutation de sécurité du même type.

4. Dispositif de commutation de sécurité selon l'une des revendications précédentes, **caractérisé par le fait que** la sortie sûre (19) commande la coupure de l'alimentation en courant d'un consommateur (15).

5. Dispositif de commutation de sécurité selon l'une des revendications précédentes, **caractérisé par le fait que** l'entrée de capteur (18) est reliée à des contacts de porte de protection comme capteur.

6. Dispositif de commutation de sécurité selon l'une des revendications précédentes, **caractérisé par le fait que** l'entrée de capteur (18) est reliée à un interrupteur d'arrêt d'urgence (16) comme capteur.

7. Dispositif de commutation de sécurité selon l'une des revendications précédentes, **caractérisé par le fait que** l'entrée (20) peut être désactivée par un circuit externe.
